# EUROPEAN PATENT SPECIFICATION

(11) **EP 2 491 569 B1**
(45) Date of publication and mention of the grant of the patent: **05.08.2020**
(21) Application number: 10824310.6
(22) Date of filing: 21.10.2010
(51) Int. Cl.: H01H 33/46, H01H 77/00, H02H 7/00

(54) **REMOTE ISOLATION SYSTEM, METHOD AND APPARATUS**
FERNISOLATIONSSYSTEM, -VERFAHREN UND -VORRICHTUNG
SYSTÈME, PROCÉDÉ ET APPAREIL D'ISOLEMENT À DISTANCE

(30) Priority: 21.10.2009 AU 2009905115
(43) Date of publication of application: 29.08.2012
(73) Proprietor: REMSAFE PTY LTD, Balcatta WA 6021 (AU)
(72) Inventor: LANE, Michael, Dianella Western Australia 6059 (AU); MROSS, Jack, Freemantle Western Australia 6160 (AU); HUGHES, Julian, Aveley Western Australia 6066 (AU); ROHRLACH, Phil, Ardross Western Australia 6153 (AU)
(74) Representative: J A Kemp LLP
(86) International application number: PCT/AU2010/001394
(87) International publication number: WO 2011/047428

(56) References cited:
- EP-A2- 0 259 101
- US-A- 4 833 592
- US-B1- 6 535 797
- US-B1- 6 535 797
- US-B1- 7 311 247
- US-B2- 6 892 115
- US-B2- 6 892 115
- US-B2- 7 151 329

## Description

### FIELD OF THE INVENTION

The present invention relates to a system, method and apparatus for isolating equipment in order to safely perform maintenance or other work on such equipment or ancillary components of the equipment.

Various types of equipment must be isolated from a range of energy sources including electrical energy (the most common) and mechanical energy including pressure and potential, to enable safe maintenance and other work. For example, conveyor belt systems used in the mining industry, for example in the North West of Western Australia, for transporting iron ore or other bulk materials, can span significant distances. These distances can be in the range of many kilometres. These conveyors are typically powered by electrical motors (3 phase electrical power is supplied and the voltage may range from low voltage, from below 600 V to 1000 V AC, to medium and high voltage in the multiple kV range and extending to above 10 kVAC and even 33 kVAC) and use brake systems which are also electrically operated (and may be designed to fail, or be de-energised, in the brake-on mode).

Unplanned downtime of such conveyor system is costly in terms of lost production and revenue. In order to undertake remedial mechanical works on a conveyor such as tramp metal removal, idler replacement and rip detector restring, the system must be rendered safe for such work to be carried out.

Although different mine procedures and relevant safety standards may apply, a typical pre-requisite before permitting mechanical maintenance or other activity involving access to the conveyor belt system involves the electrical isolation of the conveyor system. This isolation ensures that the energy source powering the conveyor belts and associated equipment (ie electrical power) is removed from all components of the system that could result in a movement of the conveyor belt. In such situations, all belt drive motors and brakes are electrically isolated.

Isolation is not achieved by actuation of emergency stopping devices such as emergency stop buttons, lanyards, rope switches and similar quick stop devices. Such devices are not designed for frequent use and cannot be locked out in all cases. In addition, emergency stopping devices may still allow energy - typically in mechanical form such as release of conveyor belt tension - to be released. Inadvertent reactivation and continued operation of control circuits are additional risks.

Because of the potential serious consequences of a conveyor belt movement whilst work is being conducted on the belt or its ancillary components, electrical isolation procedures are often very structured and require multiple levels of approvals and human interactions. For example, when a tramp metal detector triggers a belt stoppage, a known isolation procedure proceeds as follows:
1. A tramp metal detection ("TMD") fault signal is issued to a Control Room in which case the plant control system, for example a DCS (Distributed Control System), automatically initiates a stop on the relevant conveyor belt by opening first circuit interrupters, in the form of a set of primary circuit breakers and/or contactors dependent on the relevant voltage (low, medium or high) for operation of the equipment, to remove power to the relevant belt drive and brakes etc. The DCS is fully integrated to ensure that a proper belt stop procedure is followed having regard to any upstream or downstream processes that might be affected by such belt stop;
2. The Control Room Operator (CRO) is informed of the fault and requests authorised personnel to check the system and remove the fault. This step may alternatively involve personnel that are located close to the tramp metal detection station itself contacting via phone, or other communication means, the CRO and requesting isolation of the belt to allow works such as maintenance to be performed.
3. Before any activity can be performed on the conveyor belt, a duly authorised Isolation Officer must electrically isolate it. The isolation is effected by operating second circuit interrupter(s), such as a set of secondary circuit breakers, which are in series with the first circuit interrupter(s) described in item 1 above. This typically takes time as the authorised Isolation Officer may need to travel (in some cases, many kilometres) to the relevant electrical sub-station to perform the isolation, may be attending to other faults in the plant, may be carrying out other duties at the time, or are on a relief break.
4. As there is some danger of arc flash when operating the isolation mechanism to disconnect the second circuit interrupter(s), for example a set of circuit breakers in the relevant electrical sub-station, the Isolation Officer is required to wear an arc flash suit during disconnection. Disconnection is therefore an undesirable and dangerous task which again adds time delay to the overall process. Nominally, the electrical power to the conveyor belt has already been removed so that there should be no arcing or danger involved - however the isolation procedure involves the breaking of a further set of electrical contacts so that even if the CRO was to accidentally, or otherwise, request a restart of the belt system, this could not occur. In some cases, even though the belt system has stopped, one or two of the three primary circuit interrupter contacts under the control of the CRO may have welded so as to leave power to one or two of the three lines respectively (such power not necessarily being sufficient to maintain movement of the belt at that time). Breaking of the second circuit interrupters, such as circuit breakers, by an Isolation Officer could in this case lead to dangerous arcing.
5. Once the Isolation Officer has operated the isolation mechanism (for example racking down and out of the second circuit interrupter(s) or circuit breakers) the electrical isolation may be visually confirmed. That is, in racked down and out position, it can clearly be seen that no electrical contact is in place between electrical contacts and the electrical supply or "load" line.
6. The CRO or Isolation Officer then performs what is commonly known as a "Try Start" wherein a request is made of the control system to start in accordance with the normal starting procedure. Only when it is confirmed that the belt system does not start (via suitable system feedback sensor that may measure conveyor belt movement or motor pulley rotation) does the CRO inform the relevant personnel that isolation has been implemented.
7. The relevant personnel who need to attend the relevant sub-station then place one or more personal padlocks or other device on the isolation mechanism to prevent accidental re-engagement. In the example being described, mine regulations and practice demand that no person other than the owner of the padlock, in this case the relevant personnel, are permitted to remove their personal padlock. Once so padlocked the Isolation Officer informs the CRO that isolation has been completed and works or maintenance may begin. As this may take some time, the Isolation Officer may leave the sub-station and attend to other duties.
8. Upon completion of the works, the personnel inform the CRO. The CRO then requests the Isolation Officer to return to the sub-station in order to de-isolate the system. The maintenance personnel must also attend the sub-station to remove the personal padlocks. This results in additional time delay as noted in steps 4 and 5 above. The Isolation Officer then proceeds to de-isolate the system by re-engaging the first and second circuit interupters. In order to prevent an uncontrolled start, typically, a feedback from the primary circuit interrupter(s) will not permit a start or run signal to be active.
9. Once the de-isolation procedure has been completed, the Isolation Officer informs the CRO. A controlled restart of the system is then performed by the plant control system.

The above isolation method, whilst providing a high degree of safety assurance, can result in significant delays - up to and even in excess of several hours - in performing unscheduled works and maintenance typically resulting in significant costs in lost productivity and revenue, as well as exposure to safety risks in the relevant sub-station for the equipment.

US 6,535,797 B1 discloses an electrical distribution system and an associated method for of monitoring and controlling the system.

US 6,892,115 B2 discloses a method of monitoring and controlling a power distribution system.

US 7,311,247 B1 discloses a system for electronically controlling physical operation of dangerous equipment. The system reads data from an electronic key and controls the flow of electricity, air, water and/or hydraulic fluid, for example, to a piece of dangerous equipment.

### SUMMARY OF THE INVENTION

The invention is defined in the appended claims. It is a principal object of the invention to provide a safe and reliable remote isolation system whereby personnel local to the area in which work is to be carried out on equipment may procure an electrical isolation to enable work to be carried out on such equipment without the need to request or involve an Isolation Officer qualified to carry out electrical work.

With the above object in mind, in one form, the invention resides in a remote isolation system for isolating an energy source from selected equipment energisable by the energy source and controlled by a control system, wherein the system includes a remote isolation station for the selected equipment to be isolated, the remote isolation station being in communication with the control system for granting isolation on permissible request, the remote isolation station having a human machine interface for requesting an isolation of the control system, a human interpretable display for indicating that an isolation approval has been granted from the control system, and an isolation switch means for communicating to the control system that an isolation is in effect. The control system therefore allows supervision of an operator initiated isolation request without need, under permissible circumstances, for an Isolation Officer to undertake time consuming and sometimes hazardous isolation as done previously.

The remote isolation station is advantageously located proximate to the selected equipment to be isolated. By allowing maintenance and other authorised personnel to request and implement an isolation of the selected equipment at a location proximate to where the work is intended to be carried out (as opposed to having to travel to a relevant sub-station as per existing requirements), significant time and cost savings can be made. Alternatively, the remote isolation station may be located at a distance, even a significant distance, from the equipment to be isolated.

Preferably, the system is rendered in-operable if the selected equipment is in an energised (or on) state.

The remote isolation system includes first circuit interrupter(s), such as one or more isolation contacts, which are in series connection with a primary stop/start switch for the selected equipment, said first circuit interrupter(s) being controlled to the off state once isolation approval has been granted. This provides a first point of isolation. Alternatively, or in addition to the first circuit interrupter(s), the remote isolation system may advantageously include second circuit interrupter(s), for example in the form of circuit breaker(s) or other contactor(s), in an energy supply line from the energy source to the selected equipment, said second circuit interrupter(s) being under the control of the control system and being placed in the off state (ie the break position) once isolation approval has been granted. This provides a second point of isolation in the system being isolation of the energy supply line.

The system may be applied to isolation of low, medium and high voltage energised equipment, the definition of low, medium and high voltage being as above described. For low voltage applications, say below 1000 VAC, contactor(s) may be used as the second circuit interrupter(s). For medium and high voltage applications, above about 1000 VAC, operation of the second circuit interrupter(s), likely to be circuit breaker(s), may involve racking out, that is driving out of contact, to break the energy supply line. Such racking out, controlled during operation of the isolation system, also provides a visual indication of isolation. Sensor(s) may be used to confirm such racking out and locking pins should be used to lock the truck carrying electrical contacts in racked out position.

Preferably, when the energy source is electricity, the system further comprises a voltage monitoring means, such as a relay, to sense and monitor voltage downstream of the first circuit interrupters. On isolation, sensed voltage should be at or safely very close to zero volts. The voltage monitoring means should be safety rated to minimise risk of continued energisation of the equipment. To this end, the voltage monitoring means should also sense each phase of any electrical supply to the equipment. Analogues to voltage monitoring means for energy sources may be envisaged, for example pressure or flow sensors in the case of steam or working fluid as an energy source.

Preferably, the remote isolation system is configured such that upon the first and second circuit interrupters being placed in the off (or break) state, the control system cannot return these circuit interrupters to the on (or "make") state unless a predetermined permissive signal is received from the remote isolation station.

The energy source for the selected equipment may provide energy in various forms such as electrical, mechanical such as pressurised air, or mechanical and heat such as steam, or any combination of these. Therefore, the use of electrical terms in this specification, unless the context absolutely requires, is not to be taken to limit the invention to an electrical energy source. The purpose of the invention is to allow the energy supply to the equipment, in whichever form this supply happens to take, to be isolated from the equipment and therefore render the equipment in-operable for the purposes of safety during maintenance. For simplicity, the remaining discussions will reference an electrically powered conveyor belt system recognising however that the equipment need not be limited to a conveyor belt system and the power source need not be limited to electrical power.

Once the remote operator has made a request via the human machine interface of the remote isolation station, typically a Control Room Operator (CRO) will either approve or deny such request (this step may be further automated by allowing a central control system itself to approve or deny the request based on a set of permissives (i.e. preconditions that must be met for approval to be granted).

A range of permissives are possible and should be determined on a plant specific basis during design work for the isolation system. Examples of permissives include checking whether the isolation request relates to the correct equipment to be isolated, the state of other plant control indicator(s) and operator skill level. An operator, including the CRO, may be interrogated as to the permissives. In some cases, the remote isolation system may permit, either before or after an operator request, isolation on the basis of the skill level of the operator requesting the isolation. Other bases for prospectively permitting isolation may be implemented.

If approved, the remote operator is informed of such approval for isolation to proceed by a suitable indicator at the remote isolation station. Additionally, the control system may also flag this approval at other sites including other remote isolation stations and the CCR. The remote operator is then able to secure the isolation by activating the isolation switch to confirm the isolation. A time-out may apply and the authorisation may lapse after such time-out has expired.

Preferably, the isolation switch comprises a locking means for locking the switch in the isolation position with the selected equipment at least isolated from the energy source. The locking means may take the form of a hasp or other mechanically or electrically operable locking device to be personally locked, for example by key or padlock, by the operator requesting isolation, and other operators if required. The locking means prevents the isolation switch from moving out of the isolation position. The locking means may comprise a plate or other restrictor which partially or wholly covers the isolation switch to prevent movement out of the isolation position.

The locking means may be in the form of a manual lock out system, which will only allow the remote operator to lock the isolation switch when the approval for isolation is granted. The isolation cannot be removed unless the lock is physically removed and the isolation switch is manually operated. It is common practice in many industries that once a personal safety lock is applied, it may only be removed by its owner with severe penalties applying for breach of this requirement. The remote isolation system of the current invention may readily adapt this safety related procedure to allow personnel to isolate equipment and place personal locks to secure such isolation.

Further, the isolation system may comprise one or more sensors at the remote isolation station to detect that a personal lock has been secured.

Preferably, the isolation switch comprises an interlock means such as a solenoid, operable to prevent the isolation switch from being activated (ie moved into the isolation position) absent isolation approval.

This interlock means provides the desirable feature that operators cannot activate the isolation switch without having prior authorisation.

Preferably, the isolation switch comprises sensor means for sensing the fault free operation of the interlock means.

In case the interlock means is determined to be faulty, the remote isolation panel can be faulted to render it inoperable and a fault signal provided to the control system to attract maintenance attention.

Alternatively, or in addition, circuit interrupters, such as circuit breakers, in the energy supply line to the equipment to be isolated may be operated by the plant control system to isolate the equipment.

Preferably, in either case of operation of circuit interrupter(s) in the energy supply line to the selected equipment,to off or break state, authority for closing such circuit interrupter(s) is passed under the direct and exclusive control of the remote isolation station.

Preferably, the remote isolation station comprises a human machine interface for requesting a "try start", wherein upon manual activation of the interface a communication signal representative of the "try start" request is sent to the control system. Such a "try start" is consistent with requirements under safety guidelines issued by a number of work safety authorities in Australia and elsewhere.

In effect, a "try start" provides a signal equivalent to a plant control system start signal, to add further assurance that isolation authority rests with the remote isolation station. A "fail to start" signal received from the control system will confirm that the "try start" test has been passed. A "fail to start" signal may be generated if the control system confirms that no belt movements were detected and/or that no voltage (or analogous measure of motive force) appeared on the energy supply lines to the selected equipment.

The remote isolation station may include a human interpretable display for acknowledging successful completion of a "try start", grant of an isolation approval and an isolation switch for communicating that an isolation is in effect. Such a display may also be termed a human machine interface (HMI).

In use, the remote isolation station may comprise a remote panel, designed to meet necessary safety and fail safe standards and located conveniently in relation to an item of equipment to be isolated. The panel may be protected from environmental influences such as sun, heat, freezing conditions, rain, wind and/or dust. Alternatively, a number of remote panels may be placed along an associated item of equipment (eg a long conveyor belt system) and be "daisy chained" so that any isolation that is activated on one of the remote panels will prevent the de-isolation of that equipment. For example, in a conveyor belt system, a remote isolation station could be placed proximate to a tramp metal detector, or a belt rip detector.

Preferably, the isolation system further includes a master controller which acts as an interface between one or more remote isolation station(s) and a control system, typically a plant control system which may be implemented through central or distributed control. It is conventional for a plant control system to have a central control room (CCR) from which one or more control room operators (CRO) can monitor and/or effect control inputs to the plant control system. The master controller may conveniently be located in a suitable equipment room or within a sub-station and be provided with a HMI (Human Machine Interface) for allowing maintenance and other authorised personnel to access the status of the system, status of the isolation and any alarms/messages the system has generated. Such an HMI is additional to the HMI used at a remote isolation station. Preferably, where equipment to be isolated is under the control of, or otherwise in communication with an existing control system such as a DCS (Distributed Control System) or SCADA (Supervisory Control and Data Acquisition system) the remote isolation system, via the master controller, is provided with a control and diagnostic system such that status and alarms are visible from a control room of the plant. Although complete isolation of equipment is required for safety purposes, it is possible to configure the system to selectively continue energy supply to ancillary component(s) of the selected equipment in certain exceptional circumstances. For example, in the case of conveyors, even when the conveyor itself is isolated, it may be necessary to maintain an energy supply to the conveyor braking system to ensure that braking action, prevention of conveyor movement, is achieved. Other components for other equipment could remain energised in this way. The plant control system controls such energisation. Where the equipment item is driven by a variable speed device such as a variable speed driver for a motor, electrical isolation may be achieved as above described. However, as a crash or hard stop could damage the motor, it is desirably avoided. In this case, the control system includes logic to enable the variable speed device or motor to proceed through a controlled stop sequence prior to isolation allowing the variable speed device to stop with reduced risk of damage.

The remote isolation system may be retrofitted to existing equipment and plant.

In another form, the invention provides a remote isolation method for an equipment item which is under the control of a plant control system, comprising the following steps:
1. An isolation request is made from a remote isolation station via a remote human/machine interface means;
2. The plant control system receives a communication signal representative of such isolation request. Preferably, the plant control system indicates that a isolation request has been received via a a visual and/or audible alarm means;
3. The control system, or an authorised party such as a control room operator, determines the existence of required permissives and if acceptable authorises the isolation via a human/machine interface;
4. Circuit interrupter(s) is (are) controlled so as to prevent a start of the equipment via the plant control system with control being transferred to the direct and exclusive control of the remote isolation station.
5. An authorisation signal is issued to and displayed at the remote isolation station;
6. An operator at the remote isolation station activates an isolation switch to confirm that isolation is in place and this is flagged by the plant control system.

Preferably, control of the circuit interrupters at step 4 above is via a de-energisation of electrical contacts such that they fail to the off (or break) state for safety reasons.

In practice, an isolation request will only be authorised if the equipment has already been de-energised via de-activation of a stop/start switch (which is under the authority of the CRO) which activates a set of primary circuit interrupters, typically circuit breakers, to the break state so as to de-energise the equipment. At this point, the CRO has authority to re-start the equipment via the stop/start switch. In the case of moving equipment, such as a conveyor, motion detection may be used to ensure that the equipment has come to a complete stop before isolation authorisation is granted.

Preferably, isolation authorisation or approval is prevented in the case that the primary circuit interrupters have been placed in the break position and a voltage is sensed downstream by the voltage monitoring means on any one of the lines being monitored. Advantageously, a fault flag is set to alert the CRO or other personnel of a fault. Preferably the isolation method includes a further step 5a wherein a "try start" must be requested and passed before proceeding to step 6, such "try start" being consistent with requirements under safety guidelines issued by a number of work safety authorities in Australia and elsewhere.

Preferably, a time-out is activated with the effect that step 6 must be made within the time-out period having reference to step 5.

In another form, the invention resides in a remote isolation station for isolating selected equipment wherein the remote isolation station comprises:
a first indicator means for indicating a ready state of the remote isolation station;
a first human machine interface for making an isolation request;
a second indicator means for indicating that the isolation request has been granted;
a manual isolation switch means having at least two operating states, namely a normal state and a isolation state;
and a locking means for locking the isolation switch means to the isolation state.

Preferably, the locking means is in-active whilst the manual isolation switch is in the normal state.

Preferably, the first human machine interface and manual isolation switch are rendered in-active if the if the first indicator means is not indicating the ready state.

Preferably, the manual isolation switch is rendered in-active if the if the first indicator means is not indicating the ready state and the second indicator means is not indicating that an isolation request has been approved.

Preferably, the remote isolation station includes a second human machine interface adapted for requesting a "try start" of the selected equipment.

Preferably, the remote isolation station includes a third indicator means for indicating that the "try start" test has been successfully completed (ie to confirm that the equipment item did not start).

Preferably, the first human machine interface, second human machine interface and manual isolation switch are rendered in-active if the if the first indicator means is not indicating the ready state;

Preferably, the manual isolation switch is rendered in-active if the first indicator means is not indicating the ready state, the second indicator means is not indicating that an isolation request has been approved, and the third indicator means is not indicating that a try start test has been successfully completed.

In another form, the invention resides in a remote isolation switch for isolating selected equipment, the switch being switchable between at least a first state and a second state, said switch comprising:
a human machine interface for operation by an operator,
an interlock means for locking the switch to said first state and preventing actuation of the human machine interface unless certain permissives are met,
an interlock sensor means for detecting the operating state of the interlock means,
a state detection means for detecting said first state and said second state and capable of generating a machine readable signal indicative of said first and second states; and a locking means adapted to permit an operator to lock the switch in the second state. The remote isolation switch is particularly useful as an isolation switch of a remote isolation system as described hereinabove.

Preferably, the human machine interface is operably connected to an actuating mechanism also operably connected to said interlock means such that when the interlock is active the actuating mechanism is locked to said first state.

Preferably, the human machine interface is adapted to fail in preference to a failure of the interlock means in the event of excessive manual force being applied in order to move the switch from the first state to the second state.

Conveniently, this may be achieved by the choice of materials and/or design features of the manual interface portion and the actuating mechanism and the interlock means. For example, the manual interface portion may be in the form of a handle, usefully a plastic handle, and the actuating mechanism and interlock means may be metal parts designed to be able to withstand actuation forces greater than the plastic handle is capable of transmitting.

Preferably, the isolation switch means comprises a locking means for locking the isolation switch in an isolation position. The design and operation of the locking means, and an interlock means, are described above.

The isolation system, method and apparatus as above described may usefully be applied to a range of equipment. For example, and without limitation, such equipment may include various types of conveyor (screw conveyors, vibrating conveyors etc), bucket elevators, screeners, crushers, feeders (vibro-feeders, feed-gates etc), fans, blowers and pumps.

The isolation system, method and apparatus should be subjected to a risk analysis to determine probability of failure and probability of mean time to failure. Risk analysis is undertaken during the engineering design phase where a HAZOP or like analysis is undertaken to identify risks. Based on the risk analysis, a safety level or safety integrity level (SIL) is ascribed to the isolation system. A SIL rating of at least 2, and more preferably 3, is achievable with the system, method and apparatus as above described. The isolation system must be monitored periodically to ensure that the safety integrity level does not fall below an acceptable level.

A number of preferred embodiments of the invention will now be described with reference to a conveyor belt system.

### BRIEF DESCRIPTION OF THE DRAWINGS

FIG. 1 shows a schematic layout of a remote isolation system as applied to a conveyor belt system.
FIG. 2 shows a further schematic of the remote isolation system shown in Fig 1
FIG. 3 is a schematic layout of a front panel of a remote isolation stations.
FIG. 4 shows are more detailed view of a front panel of a remote isolation station.
FIG. 5 shows an isolation switch in the ready state.
FIG. 6 shows an isolation switch in the "isolation active state" prior to a padlock being applied.
FIG. 7 shows an isolation switch in the "isolation active state" subsequent to a padlock being applied.
FIG. 8 shows a cross-section through and isolation switch.
FIG. 9 shows a flow diagram for a remote isolation procedure.
FIG. 10 shows a flow diagram for a remote de-isolation procedure.
FIG. 11 shows a partial detail schematic for a remote isolation system, similar to that depicted in FIG. 2 but applied to a medium or high voltage conveyor system with a variable speed conveyor drive.
FIG. 12 shows a partial detail schematic for a remote isolation system, similar to that depicted in FIG. 2, for a low voltage conveyor system with a variable speed conveyor drive.
Similar reference characters denote corresponding features consistently throughout the attached drawings.

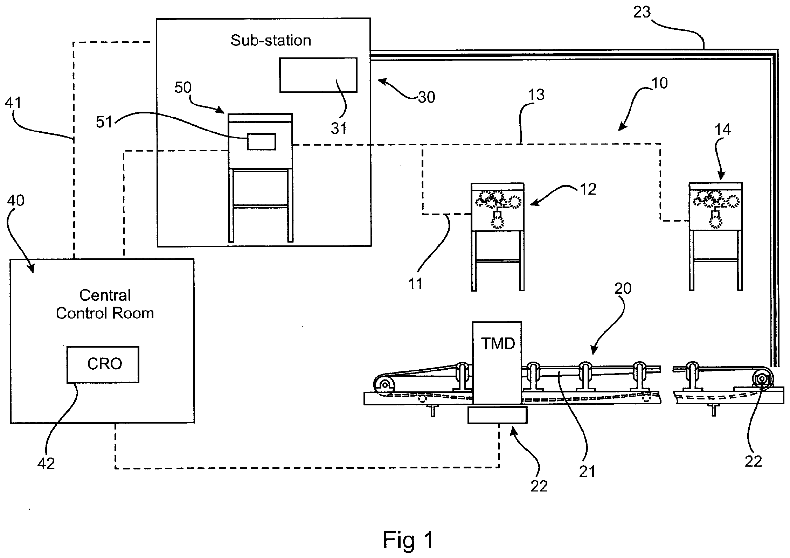

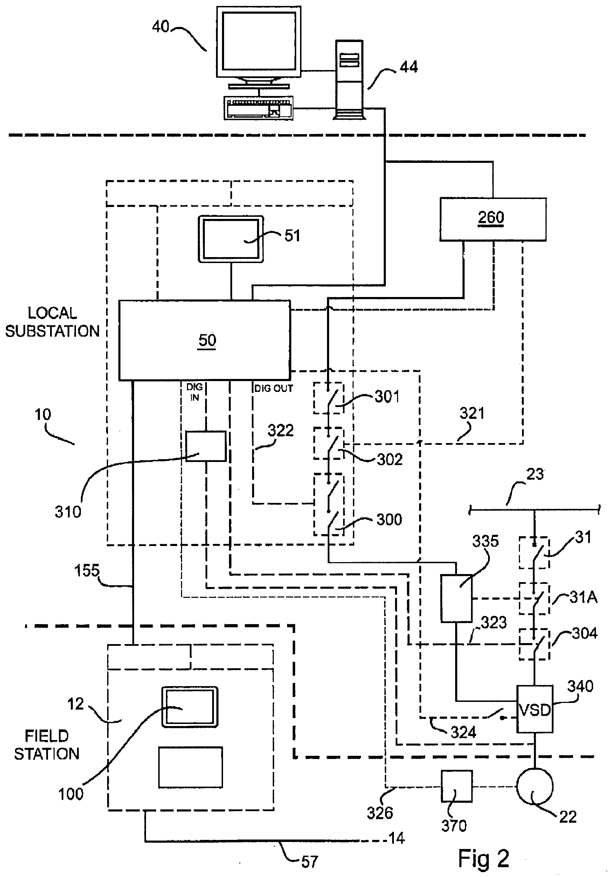

Referring to Fig 1, there is shown a schematic layout of a remote isolation system 10, as retrofitted on an existing conveyor belt system 20 for example a long range conveyor system for conveying iron ore from a mine site to a port for shipment. The conveyor belt system 20 comprises a troughed conveyor belt, 21, having a head pulley motor 22 driven by an electrical supply through electrical contacts 31, whether contactors or circuit breakers, as illustrated in Fig. 2. One contact 31 is a standard contactor 31A for "ON"/"OFF" operation of the motor drive 335 for motor 22. The head pulley motor 22 is powered through motor drive 340 by a variable speed device (VSD) 340 which is electrically powered from a 3 phase AC power supply line 23 with voltage less than 1000 VAC. The electrical power is supplied from a sub-station 30. The sub-station 30 houses the contactors 31. Activation of the contactors 31 (ie placing them in the "off' or "break" state), de-energises all 3 phases of the electrical supply to the conveyor head pulley motor 22.

The conveyor belt system 20 and sub-station 30 are under the control and supervision of a plant control system 260 having a central control room (CCR) 40, via a DCS (distributed control system) or SCADA (Supervisory Control and Data Acquisition system) 44 as are commonly used and would be well understood by the skilled addressee. Items 41 are representative of communication and control network between the CCR and the various other systems and components. A Control Room Operator (CRO) 42 is located within the CCR and has various input/output devices (I/O) and displays available (not shown) for the proper supervision and control of the conveyor belt system 20. Except for the remote isolation system, 10, the above description represents what may be considered a conventional system.

The remote isolation system, 10, comprises remote isolation stations 12 and 14 which are located proximate to the equipment that they are intended to isolate, in this case conveyor belt system 20. The remote isolation system 10 also includes a master controller, 50. The master controller 50 incorporates a human/machine interface (HMI) in the form of a touch sensitive screen, 51 which displays human interpretable information. The master controller 50 is placed within the sub-station 30. The remote isolation stations 12 and 14 are in communication with master controller 50, communication line 155 for remote isolation station 12 being shown, and each other, via communication channels 11, 13, 155 and 57 (in Fig 2) respectively. These communications channels 11, 13, 155 and 57 may be in any suitable form including hard wired or wireless forms.

Referring now to Fig 2, there is shown a further schematic of the remote isolation system 10 shown in Fig 1 highlighting the control and communications systems. First circuit interrupters being a set of isolation contacts 300 are placed in series connection with an emergency stop switch 301 and a primary stop/start switch 302 (the latter two of which would normally be found in a conventional system). First circuit interrupters 300, and switches 301 and 302 form part of the control system that controls second circuit interrupter(s) 304, for low voltage applications contactor(s), in accordance with the invention. Second circuit interrupter 304 is a critical element of the remote isolation system 10. Dependent on the voltage of the system, second circuit interrupter(s) 304 will be contactor(s) (low voltage) or rackable circuit breaker(s) (high voltage). Contacts 300, forming an important part of the remote isolation system 10, are in the form of a plural switch which incorporates self diagnostics and is designed so that a loss of power results in the contacts 300 moving to the off or break state.

As shown in Fig 2, there is provided a digital out ("DIG OUT") control line 321 to the stop-start switch 302 not necessarily controlled by the remote isolation system, 10, rather being controlled by plant control system 260. Remote isolation system 10 may control stop-start switch 302. This control line 321 is not relied upon to achieve isolation of conveyor belt system 20 though it may be used to sense that a current isolation is in effect. Master controller 50 controls both the first circuit interrupter 300 and the second circuit interrupter 304 as shown by control lines 322 and 323 respectively.

A voltage monitor or relay 310 senses and monitors the voltage down-stream of the second circuit interrupter 304. Although not shown in Fig 2, the voltage monitor 310 senses and monitors each of the individual 3 phases supplied to the motor 22 and provides a status signal to the master controller 50. The voltage monitor 310 is a device certified for safety compliance and incorporates self diagnostics because its role is to ensure that risk of continued energisation of conveyor belt system 20 following an authorized isolation is prevented. For voltages above about 600 VAC, the voltage monitor 310 may incorporate a voltage transformer (not shown) to step down the voltage for final sensing and monitoring.

Zero speed sensor 370 is included to provide further safety assurance that the head pulley motor 22 and conveyor 21 is not running. Master controller can implement the correct action if zero speed sensor 370 sends a signal inconsistent with isolation (see control line 326).

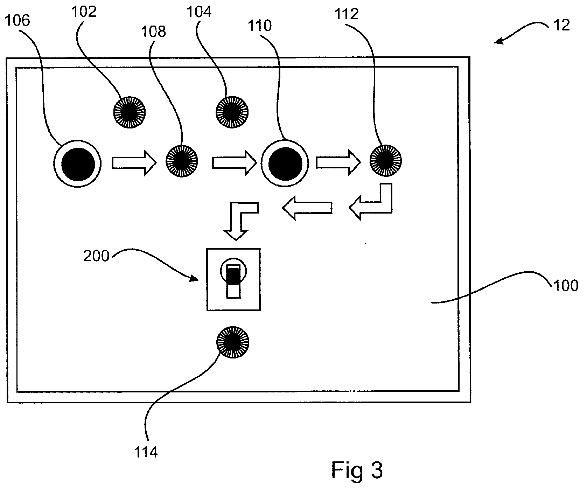

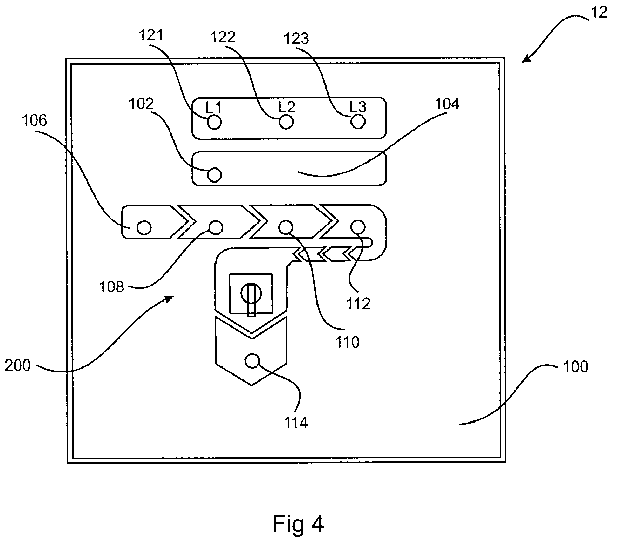

The front panel 100 of either of the remote isolation stations 12 and 14 is shown in schematic form in Fig 3 which shows the panel in the normal state (that is, when no isolation is in effect). Fig 4 shows a further variation of the front panel 100 which includes additional graphics and instructions which aid in the proper operation of the remote isolation system.

The front panel 100 has a first indicator means in the form of status indicator light 102 which glows to indicate that the remote isolation system 10 is ready and available for an isolation request, a first human machine interface in the form of a manual device, an isolation request button 106 which an operator presses to commence the isolation request, a second indicator means in the form of an isolation authorization indicator light 108 which initially flashes to indicate that an isolation request has been made and subsequently glows solid if the request has been granted, and a manual isolation switch 200, which the operator operates to secure the isolation (further details of the isolation switch 200 are provided below). The front panel 100 also includes a second manual interface means in the form of a "try start" button 110 which is pressed by the operator to ensure that the conveyor belt 21 does not start, and a third indicator means in the form of a "proceed to isolate" light 112 which glows once the try start test has been successfully completed (ie a fail to start signal is registered by the control system). A further display means in the form of an "isolation complete" indicator light 114 is also included to clearly indicate that an isolation is in effect. The first, second and third indicator means provide a human interpretable display. The front panel 100 generally may also form part of such display.

The front panel 100 shown in Fig 4 has a set of additional indicator lights 121, 122, and 123 for indicating that a voltage is present on each of the respective 3 phases of electrical power provided to the equipment. When the conveyor system 20 is in the normal operating state all of the lights 121, 122 and 123 will be on and the light 102 will be off (indicating that the system is not ready for isolation). However, in the event that conveyor belt 21 has been stopped (for instance, as a result of detection of tramp metal by the Tramp Metal Detector 22) and the primary circuit breakers 304 have been placed in the break state, any one of the lights 121, 122 or 123 remaining on will indicate a fault and light 104 will illuminate. Such a situation may arise if one or more of the lines of the second circuit interrupter(s) 304 has welded and failed to break. In this case light 102 will also remain off to indicate that the system is not ready.

The indicator lights 102, 104, 108, 112 and 114 are all monitored for proper operation by a diagnostic check (for example by applying a test voltage - preferably insufficient to illuminate the light - and checking for an open circuit). For this reason, incandescent lights may prove more economical over and above alternatives such as Light Emitting Diodes (LED's) as checking for a circuit through the light filament is a relatively simple process. Multiple indicator lights and/or multi-filament bulbs may also be incorporated for additional reliability and longevity before replacement is required. The system is configured so that any fault will be reported to the master controller, 50, and thereby to the CCR. A fault in the remote isolation system 10 will render the system to the "last known state" in a fail-safe manner. If LED's are to be used, suitable diagnostics can be applied to provide fault detection (for example a photo-sensitive resistor may be used to positively confirm that the LED is illuminating).

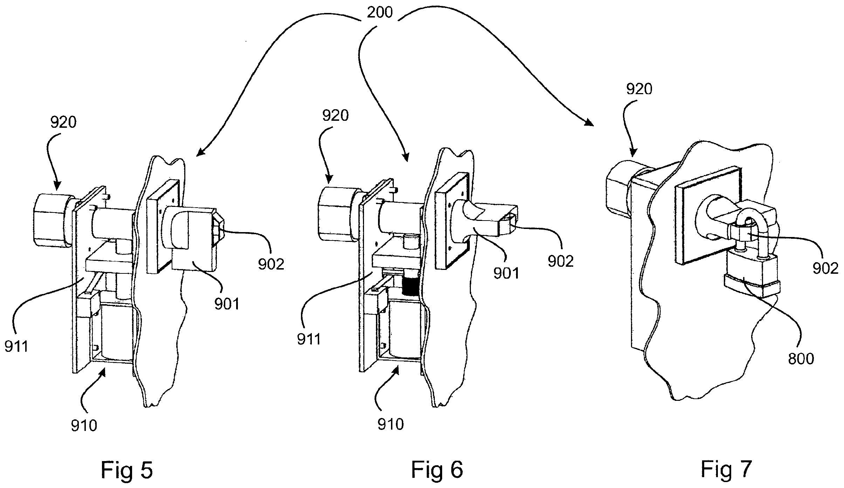

Referring now to Figs 5, 6 and 7 there is shown the remote isolation switch 200 in various states. Fig 5 shows the isolation switch 200 in a first state, being in a normal state as seen in Figs 3 and 4. Fig 6 shows the remote isolation switch 200 in a second state, namely an isolation state, before any personal locks have been secured to the isolation switch 200. Fig 7 shows the isolation switch 200 in the isolation state and with a padlock 800 applied to secure the isolation. Whilst the isolation switch 200 is in this "isolation active" state, de-isolation of the conveyor belt system 20 cannot occur and run contacts 300 cannot be closed.

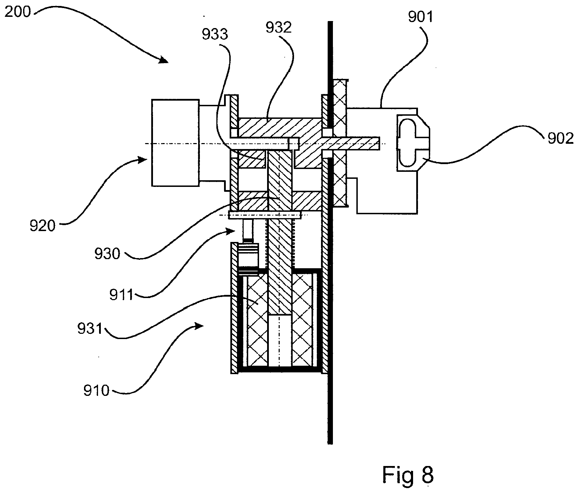

As may be best seen in Fig 8, isolation switch 200 comprises a manual interface portion in the form of a plastic handle 901, an interlock means, in the form of a solenoid 910, an interlock sensor means in the form of a reed micro-switch 911, a state detection means in the form of a two-state contact switch 920, and a locking means in the form of a lockout hook 902.

The isolation switch 200 is configured such that the lockout hook 902 does not become accessible to the operator unless and until the handle 901 is positioned to the "isolation active" state.

The solenoid 910 includes an actuator pin 930 which is actuated by an electrically powered coil 931. A shaft 932 connects the isolation switch handle 901 to the two-state contact switch 920 so that rotation of the plastic handle 901 is transmitted by the shaft 932 to the switch 920.

The shaft 932 includes an aperture 933 which receives the actuator pin 930 when the handle 901 is in the "ready" state orientation and prevents shaft 932 rotating when so engaged. The actuator pin 930 is biased by a biasing spring (not shown) to the upward direction (as viewed in Fig 8) when the solenoid 931 is in the de-energised, or off, state. The micro switch 930 detects that the actuator pin 930 is engaged with the aperture 933 (the mirco-switch only being activated upon a pre-determined displacement of the actuator pin which corresponds to engagement with the aperture 933.

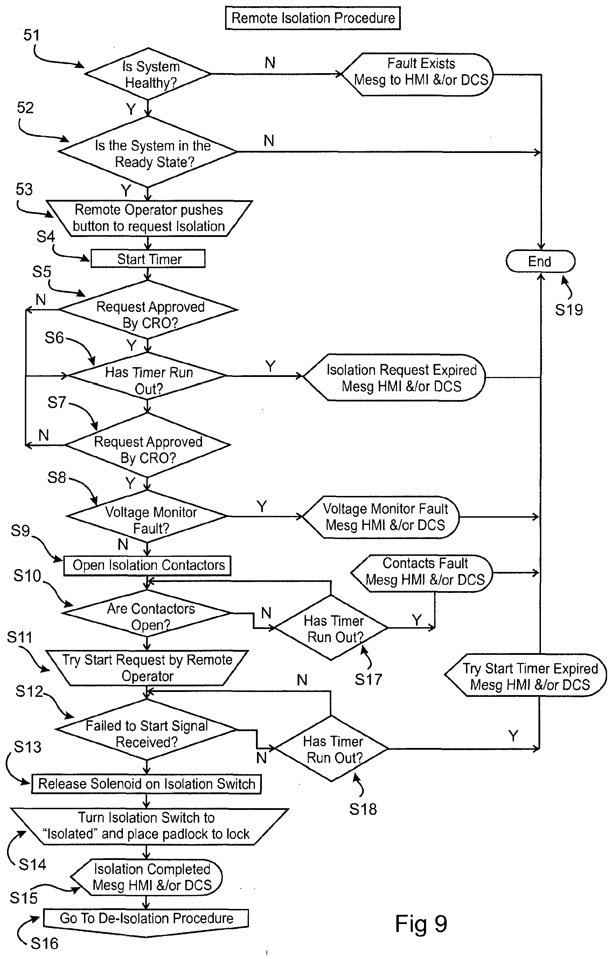

Operation of the remote isolation system 10 will now be described with reference to the generalised logic flow chart shown in Fig 9.

At step S1, the system undergoes a check for any existing faults or alarms that would prevent an isolation request from being granted, approved or authorised. If no relevant faults exist, then step S2 checks whether the system 10 is in a ready state. In the case of the conveyor system 20 shown in Figs 1 and 2, the conveyor 21 must have come to a complete stop, as sensed by zero speed sensor 370, and the voltage monitor or relay 310 must indicate that no voltage exists on any of the 3 phase supply lines before the system is deemed to be in a ready state. If step S2 is satisfied, the indicator light 102 will glow solid on the remote isolation station panel 100 (as seen in Figs 2 and 4). If not then a flag or fault message will be generated at the master controller HMI, 51, and/or at the CCR.

At step S3, an operator situated at a remote isolation station (for example station 12 of Figs 1 and 2) presses the isolation request button 106. This request is forwarded through communication line 155 to master controller 50 and plant control system 260 and onward to the CCR. The indicator light 108 then flashes to indicate registration of the request by plant control system 260. Step S3 results in a signal being sent to the CCR which may be displayed for the attention of a CRO. At the CCR, either the control system itself or a CRO considers the isolation request and makes a determination whether to grant the request or not. At step S4, a time-time out timer is started. This timer may be set for any convenient period, for example 5 minutes.

At Step S5, the system 10 awaits grant of an isolation approval from the CCR and/or the CRO. The CRO may determine that the isolation may be approved, possibly after interrogation of the operator to assess whether permissives to isolation have been met, in which case the CRO may confirm approval of the isolation request by activating switch or via a mouse click where a suitable human machine interface is provided. Permissives may include requesting operator skill level, consistency of the isolation request with known operating state of the conveyor belt system 20 and so on.

Step S6 is a check that isolation approval is granted within the timer period. If not a timer expire message is issued and the process moves to Step 19 in which case the status quo of the system is maintained (in this case, no isolation has been effected).

Step S7 is part of the timer loop which checks that an approval has been received during the preset time. Thus inaction by the CRO, or a positive decision by the CRO not to grant approval of an isolation request will result in a time out and moving to Step S19. Inaction by the CRO may be permitted by system 10 where the operator requesting approval of an isolation request has received prior authorization for isolation, for example due to the operator's skill level. That is, certain permissives for isolation may effectively be met prior to making of an isolation request.

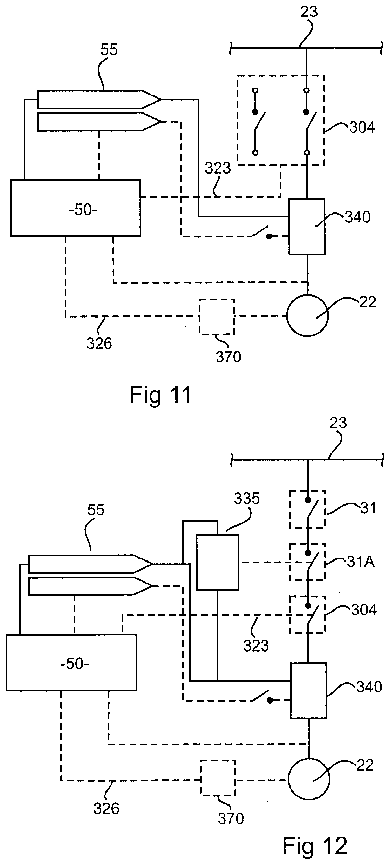

At step S8, plant control system 260 checks the status of the voltage monitor 310 (per Fig 2). At this stage, the stop/start switch 302 should already be in the off or break state such that the second circuit interrupter 304 is also in the off or break state as shown in Figs 2 and 12. Where the voltage in the energy supply or load line 23 to conveyor belt system 20 is in excess of about 1000 VAC, second circuit interrupter 304 may be comprised by rackable circuit breaker(s) - as conveniently illustrated in Fig 11 - and moving circuit breaker(s) 304 to a break state involves a controlled racking out process where a break of the electrical circuit is visually confirmed. Circuit breaker(s) 304 may be locked in break position by locking pins. The locked position may be sensed and indicated at remote control station 12 and the CCR. The locked position may also be communicated to master controller 50 and indicated at remote control station 14 communicated with remote isolation station 12 through communications line 57 (per Fig 2).

Provided that a zero voltage status is returned by the voltage monitor or relay 310 the remote isolation system 10 moves to step S8 wherein the first circuit interrupters 300 are placed in the off or break state creating a further point of isolation. The system has now been isolated at two points of isolation - in the control circuit and the energy supply line 23 - by first circuit interrupters 300 and second circuit interrupters 304 - all under supervision of plant control system 260. Works on conveyor belt system 20 may proceed.

As there may be some delay in the operation of the first circuit interrupters 300, step S9 ("open isolation contactors") performs a check to confirm that the first circuit interrupters 300 are in the off or break state as required for isolation. The first circuit interrupters 300 are provided with self diagnostics and are able to report their status to the master controller 50. If the system does not register that the first circuit interrupters 300 are in the off or break state within the timer period then a fault flag is generated and the remote isolation system 10 moves to step S9 in which the last known state of the system is maintained.

If Step S10 has been passed, then indicator light 108 is made to glow solid at a panel of remote isolation station 12. A similar indicator light may also operate at remote isolation station 14 as the two stations are communicated with the master controller 50 and plant control system 260.

Step S11 requires the remote operator to press the button 110 on the remote isolation station panel 100 (see Figs 3 and 4). This results in the plant control system closing the start/stop switch 302. The plant control system 260 monitors one or more sensors and/or inputs to determine if the conveyor 21 and/or motor 22 have started (see Fig 1).

Steps S12 and S18 provide a timed loop to check that the try start test, as required by safety guidelines, has been passed (a pass being registered if a failed to start signal has been issued by the plant control system 260 - otherwise the step will time-out and a fail flag will be registered). Steps S11, S12 and S18 may not be required in certain jurisdiction or at certain mine sites.

At Step S15 the indicator light 112 glows solid. The coil 931 is activated and the pin 930 is retracted from the aperture 933. The operator then turns the handle 901, which places the isolation switch 200 in the "isolation active" state which is sensed by the two-state contact switch 920 and a corresponding signal is issued to the master controller 50. The remote operator then pulls out the padlock hook 902 and places his personal lock (or a hasp to which a plurality of personal locks may be secured).

The remote isolation is now complete and secured. Some other features of the remote isolation system 10 may also be described. First, the plant control system 260 allows for the variable speed drive 340 for motor 22 driving conveyor 21 to proceed through a preprogrammed stop sequence to avoid a crash or hard stop that could damage the variable speed drive 340. Such control is supervised through logic drives 55 supervised by master controller 50 as schematically shown in Figs 11 and 12. Second, conveyor system 20 includes a braking system (not shown). Power supply may, in exceptional circumstances, be continued to the conveyor braking system so that brakes are operable, for safety reasons, during works performed on conveyor belt 21.

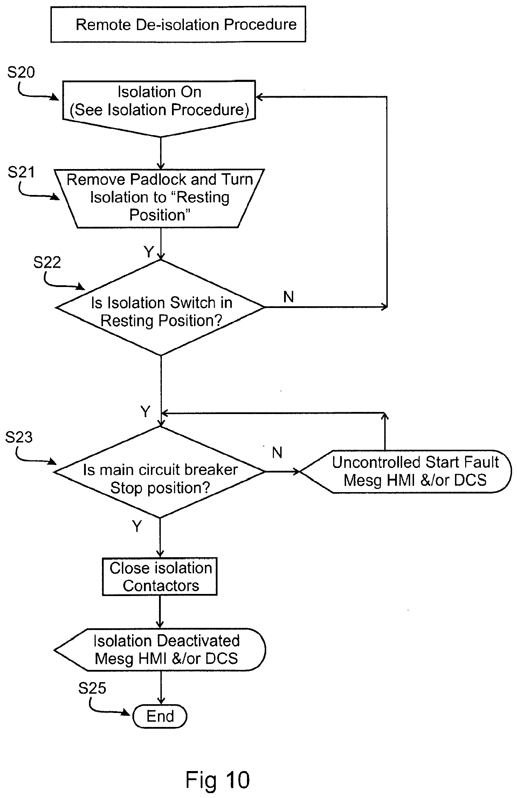

Reference is now made to the remote de-isolation procedure as indicated in Fig 10.

At Step S20 of Fig 10, the remote operator removes his personal padlock from the padlock hook 902 of the isolation switch 200, the hook 902 is pressed into its in-active state and the operator turns the handle 901 back to the "ready" state. This action is sensed by the switch 920 and a signal is sent to the master controller 50 to indicate that a de-isolation has been requested. The biasing spring (not shown) acting on the solenoid pin 930 urges the pin 930 into the aperture 933. The operator is now no longer able to operate the isolation switch without proceeding back to Step S1 described above.

Step S22 checks that the isolation switch 200 is back to the "resting state". This is done via sensing the state of the two-state switch 920. If so confirmed, the system proceeds to Step S23. Step S23 is intended to prevent an "uncontrolled start" by ensuring that the stop-start switch 302 in the off position so that re-activation of first circuit interrupters 300 will not result in an activation of the second circuit interrupter 304 and thereby a re-energisation of the conveyor 21. If Step S23 is failed, a flag is raised and the system holds its current state. If Step S23 is passed, the process moves to Step S24 ("close isolation contactors") in which the first circuit interrupters 300 are activated to the close, or make, state. The de-isolation is now complete and the CRO or plant control system can proceed to re-start the conveyor belt system 20 according to normal procedures.

The remote isolation system, 10, is in the form of a programmable electronic system (programmable logic controller) dedicated to providing safe remote isolations for the conveyor belt system 20 whenever required for maintenance or other works purposes. The remote isolation system 10 is designed for the safe remote isolation of the conveyor belt system 20, without need for an Electrical Isolation Officer or Electrician to follow a complex protocol as above described. This form of isolation is primarily intended for mechanical works and to minimise production downtime during short term isolations for minor mechanical works such as clearing jams and blockages. The system may however be adaptable for other forms of isolation.

The remote isolation system 10 is a stand-alone system, with a human-machine interface 51 and communications connection to the existing DCS or SCADA system. The resulting communications system transmits and receives data like:
- Isolation requests and authorisation.
- Other plant control requests and authorisation where necessary.
- Remote isolation stations hardware status.
- Remote isolation stations operational status.
- Isolation status.
- Communications fieldbus status and alarms.
- General alarms
- Activities log data
, tasks extending to operational functions beyond isolation of equipment.

The HMI performs no conveyor control and is purely for indication and monitoring of the system. The existing plant DCS or SCADA system will control the conveyor belt system 20 and will authorise the activation of a remote isolation. The CCR can therefore access all the system data and also monitor the system.

The remote isolation system 10 meets the following general requirements:
- Programmable Electronic (PE) technology is used for the systems logic solver. The selected system is intended to be certified by a competent body, such as TUV, required to accommodate the most stringent protection category implemented in the system. The remote isolation system is designed to meet a SIL 3 rating.
- The system master controller, 50, is located in an equipment room (not shown) and housed in a suitable enclosure.
- The remote isolation stations 12, 14 are located in the field and housed in suitable weather-proof enclosures. Componentry is selected to cope with extreme temperatures, either heat or cold, if applicable.
- Communications between the master controller and the DCS or SCADA is via Modbus TCP/IP protocol other protocols may be implemented if required
- Communications between the master controller 50 and remote stations 12, 14, is via safety rated communications protocol software, for example: InterSafe™ or PROFIsafeTM. Safety rated software, which includes protection from unauthorised modification, is highly important for use in the remote isolation system. The software packages are TUV certified up to at least SIL 3. This will ensure the communications links 11, 13, 155, 57 and so on are monitored and diagnostic tools are available for fault control and rectification.
- The remote isolation system 10 also incorporates a manual lock out system.
- All functions are designed such that movement of the final element to the isolation position will be performed by removing power from the element (i.e. de-energize to trip). Where this is not possible such as with shunt trips, suitably certified line-monitored output modules would be used.

The remote isolation system 10 is designed for compliance with mining regulations and applicable standards including Australian Standard AS 1755-2000 "Conveyors-safety requirements", AS 61508-1999 (ASIEC/EN 61508-1998) "Functional Safety of electrical/electronic safety-related systems", IEC/EN 61511-2004 (IEC/EN 61511-2003) "Functional Safety-Safety instrumented systems for the process industry sector", IEC/EN 62061-2005 "Safety Machinery - Functional Safety of safety-related electrical, electronic and programmable electronic systems" and IEC/EN 61024-2007 "Machine Safety", relevant portions of which are hereby incorporated herein by reference. The remote isolation system is certifiable to the SIL 3 level of safety by appropriate use of safety rated hardware and software components as above described. However, to maintain such a safety level, regular monitoring of the isolation system is required to ensure that SIL rating does not track back below SIL 2 or lower which could occur over a period of months. It is anticipated, following a time integrity frequency ("TIF") test, that 3 to 6 monthly servicing of the remote isolation system would be required to maintain the SIL 3 rating. Servicing would involve standard function testing and physical testing of system components.

Although the above description has been directed to conveyor belt systems that are electrically powered, the invention is not limited to conveyor belt systems or to electrically powered systems, but is equally applicable to other equipment and energy sources, such as for example, pneumatically powered robotic systems wherein an uncontrolled motion of a robotic arm may cause a hazard to maintenance personnel. In such case, the remote isolation system of the current invention would provide a system and apparatus to confirm that the pneumatic supply system was properly isolated from the robotic arm. Other modifications and variations of the remote isolation system, method and apparatus of the invention may be apparent to skilled readers of this disclosure. The scope of the invention is defined in the appended claims.

## Claims

1. A remote isolation system (10) for isolating an energy source from selected equipment (20,21) energisable by the energy source and controlled by a control system (260), wherein the system includes a remote isolation station (12,14) for the selected equipment (20,21) to be isolated, the remote isolation station (12,14) being in communication with the control system (260) for granting isolation on permissible request, wherein the remote isolation station (12,14) comprises a human machine interface (51) for requesting an isolation of the control system (260), a human interpretable display for indicating that an isolation approval has been granted from the control system(260), and an isolation switch means (200) for communicating to the control system (260) that an isolation is in effect and **characterised by** the remote isolation station (12,14) being remote from a relevant sub-station(s) (30) providing the energy source; and the remote isolation system (10) including first circuit interrupter(s) (300) which are in series connection with a primary stop/start switch (302) for the selected equipment (20,21) to be isolated, said first circuit interrupter(s) (300) being controlled to the off or break state once isolation approval has been granted; wherein optionally the system (10) includes second circuit interrupter(s) (304) in an energy supply line from the energy source (30) to the selected equipment (20,21), said second circuit interrupter(s) (304) being under the control of the control system (260) and being placed in the off or break state once isolation approval has been granted.

2. A system (10) as claimed in claim 1 wherein the remote isolation station (12,14) is located proximate to the equipment (21) to be isolated.

3. A system (10) as claimed in claim 1 or 2 rendered in-operable if the selected equipment (20,21) is in an energised (or on) state.

4. A system (10) as claimed in any one of the preceding claims wherein operation of circuit interrupter(s) (300, 304)involves racking out to break the energy supply line;
wherein sensor(s) confirm racking out.

5. A system (10) as claimed in claims 4 to 5 comprising, when the energy source includes electricity, a voltage monitoring means (310) to sense and monitor voltage downstream of the circuit interrupter(s) (300, 304).

6. A system (10) as claimed in claims 4 or 5 wherein, in case of operation of circuit interrupter(s) (300, 304) in the energy supply to the selected equipment to off or break state, authority for closing the circuit interrupter(s) (300, 304) is passed under the direct and exclusive control of the remote isolation station (12, 14).

7. A system (10) as claimed in any one of the preceding claims wherein the isolation switch (200) comprises a locking means (200, 800) for locking the isolation switch (200) in the isolation position with the selected equipment (20, 21) at least isolated from the energy source;
wherein optionally the system (10) comprises one or more sensors at the remote isolation station (12, 14) to detect that a personal lock (800) has been secured at the locking means (200).

8. A system (10) as claimed in any one of the preceding claims comprising an interlock means (910) operable to prevent the isolation switch (200) from being activated absent isolation approval.

9. A system (10) as claimed in any one of the preceding claims further comprising a human machine interface (51) for requesting a "try start" wherein, upon manual activation of the interface, a communication signal representative of the "try start" request is sent to the control system (260) and a human interpretable display for acknowledging successfully completed, an isolation approval has been granted and that an isolation is in effect.

10. A system (10) as claimed in any one of the preceding claims being configured to selectively continue energy supply to ancillary component(s) of said selected equipment (20, 21);
wherein optionally said ancillary component(s) include a conveyor braking system.

11. A system (10) as claimed in any one of the preceding claims wherein said selected equipment (20, 21) is driven by a variable speed motor (22, 340) and the control system (260) enables the variable speed motor (22, 340) to proceed through a controlled stop sequence prior to isolation.

12. A remote isolation station (12, 14) for isolating selected equipment (20, 21) as defined in any one of the preceding claims wherein the remote isolation station (12, 14) is remote from a relevant sub-station(s) (30) providing the energy source and comprises:
a first indicator means for indicating a ready state of the remote isolation station;
a first human machine interface for making an isolation request;
a second indicator means for indicating that the isolation request has been granted;
a manual isolation switch means having at least two operating states, namely a normal state and a isolation state; and
a locking means for locking the isolation switch means to the isolation state.

13. A remote isolation switch means (200) for isolating selected equipment (20, 21) as defined in any one of the preceding claims being switchable between at least a first state and a second state, said isolation switch means (200) being remote from a relevant sub-station(s) (30) providing an energy source to the selected equipment, and comprising:
a human machine interface for operation by an operator,
an interlock means for locking the switch (200) to said first state and preventing actuation of the human machine interface unless certain permissives are met,
an interlock sensor means for detecting the operating state of the interlock means (910),
a state detection means for detecting said first state and said second state and capable of generating a machine readable signal indicative of said first and second states; and
a locking means (800) adapted to permit an operator to lock the switch (200) in the second state
wherein optionally said second state is an isolation position.

14. Equipment as defined in any one of the preceeding claims being a conveyor belt system (20, 21).

## Patentansprüche

1. Fernisolationssystem (10) zum Isolieren einer Energiequelle von einer ausgewählten Anlage (20, 21), die von der Energiequelle mit Energie versorgt werden kann und von einem Steuerungssystem (260) gesteuert wird, wobei das System eine Fernisolationsstation (12, 14) für die ausgewählte Anlage (20, 21) beinhaltet, die isoliert werden soll, wobei die Fernisolationsstation (12, 14) in Kommunikation mit dem Steuerungssystem (260) ist, um auf zulässige Anfrage eine Isolierung zu erteilen, wobei die Fernisolationsstation (12, 14) eine Mensch-Maschine-Schnittstelle (51) zum Anfordern einer Isolierung des Steuerungssystems (260), eine vom Menschen interpretierbare Anzeige zum Anzeigen, dass eine Isolierungsgenehmigung von dem Steuerungssystem (260) erteilt wurde, und ein Isolationsschaltmittel (200) zum Melden an das Steuerungssystem (260), dass eine Isolation in Kraft ist, umfasst, und **dadurch gekennzeichnet, dass** die Fernisolationsstation (12, 14) von (einer) relevanten Unterstation(en) (30) entfernt ist, die die Energiequelle bereitstellen; und dass das Fernisolationssystem (10) (einen) Stromkreisunterbrecher (300) beinhaltet, der/die in Reihe mit einem primären Stopp-/Startschalter (302) für die zu isolierende ausgewählte Anlage (20, 21) verbunden sind, wobei der/die erste(n) Stromkreisunterbrecher (300) in den Aus- oder Unterbrechungszustand gesteuert werden, sobald die Isolationsgenehmigung erteilt wurde; wobei optional das System (10) (einen) zweite(n) Leistungsschalter (304) in einer Energieversorgungsleitung von der Energiequelle (30) zu der ausgewählten Anlage (20, 21) beinhaltet, wobei der/die zweite(n) Leistungsschalter (304) unter der Steuerung des Steuerungssystems (260) sind und nach Erteilung der Isolationsgenehmigung in den Aus- oder Unterbrechungszustand versetzt werden.

2. System (10) nach Anspruch 1, wobei sich die Fernisolationsstation (12, 14) in der Nähe der zu isolierenden Anlage (21) befindet.

3. System (10) nach Anspruch 1 oder 2, das unbrauchbar gemacht wird, wenn sich die ausgewählte Anlage (20, 21) in einem unter Spannung stehenden (oder eingeschalteten) Zustand befindet.

4. System (10) nach einem der vorherigen Ansprüche, wobei der Betrieb von (einem) Leistungsschalter(n) (300, 304) ein Ausfahren beinhaltet, um die Energiezufuhrleitung zu unterbrechen;
wobei der/die Sensor(en) ein Ausfahren bestätigen.

5. System (10) nach den Ansprüchen 4 bis 5, umfassend, wenn die Energiequelle Elektrizität beinhaltet, eine Spannungsüberwachungseinrichtung (310) zum Erfassen und Überwachen von Spannung stromabwärts von dem/den Leistungsschalter(n) (300, 304).

6. System (10) nach Anspruch 4 oder 5, wobei im Fall des Betriebs von (einem) Leistungsschalter(n) (300, 304) in der Energieversorgung der ausgewählten Anlage in den Aus- oder Unterbrechungszustand die Berechtigung zum Schließen des/der Leistungsschalter(s) (300, 304) unter die direkte und ausschließliche Kontrolle der Fernisolationsstation (12, 14) übertragen wird.

7. System (10) nach einem der vorherigen Ansprüche, wobei der Isolationsschalter (200) eine Verriegelungseinrichtung (200, 800) zum Verriegeln des Isolationsschalters (200) in der Isolationsposition umfasst, wobei die ausgewählte Anlage (20, 21), mindestens von der Energiequelle isoliert ist;
wobei optional das System (10) einen oder mehrere Sensoren an der Fernisolationsstation (12, 14) umfasst, um zu erfassen, dass eine persönliche Verriegelung (800) an der Verriegelungseinrichtung (200) angebracht wurde.

8. System (10) nach einem der vorherigen Ansprüche, umfassend eine Verriegelungseinrichtung (910), die betrieben werden kann, um zu verhindern, dass der Isolationsschalter (200) bei fehlender Isolationsgenehmigung aktiviert wird.

9. System (10) nach einem der vorherigen Ansprüche, ferner umfassend eine Mensch-Maschine-Schnittstelle (51) zum Anfordern eines "Start versuchen", wobei bei manueller Aktivierung der Schnittstelle ein für die "Start versuchen"-Anforderung repräsentatives Kommunikationssignal an das Steuersystem (260) gesendet wird und eine vom Menschen interpretierbare Anzeige zum Bestätigen einer erfolgreichen Durchführung, eine Isolationsgenehmigung erteilt wurde und dass eine Isolation in Kraft ist.

10. System (10) nach einem der vorherigen Ansprüche, das konfiguriert ist, um eine Energieversorgung von Nebenkomponenten der ausgewählten Anlage (20, 21) selektiv fortzusetzen;
wobei optional die Nebenkomponenten(n) ein Förderer-Bremssystem beinhalten.

11. System (10) nach einem der vorherigen Ansprüche, wobei die ausgewählte Anlage (20, 21) von einem Motor variabler Drehzahl (22, 340) angetrieben wird und das Steuersystem (260) es dem Motor variabler Drehzahl (22, 340) ermöglicht, vor einer Isolierung eine gesteuerte Anhaltesequenz zu durchlaufen.

12. Fernisolierstation (12, 14) zum Isolieren einer ausgewählten Anlage (20, 21), wie sie in einem der vorhergehenden Ansprüche definiert ist, wobei die Fernisolierstation (12, 14) von (einer) relevanten Unterstation(en) (30) entfernt ist, die die Energiequelle bereitstellen, und Folgendes umfasst:
eine erste Anzeigeeinrichtung zum Anzeigen eines Bereitschaftszustands der Fernisolationsstation;
eine erste Mensch-Maschine-Schnittstelle zum Ausführen einer Isolationsanforderung;
eine zweite Anzeigeeinrichtung zum Anzeigen, dass der Isolationsanforderung stattgegeben wurde;
eine manuelle Isolationsschaltereinrichtung mit mindestens zwei Betriebszuständen, nämlich einem Normalzustand und einem Isolationszustand; und
ein Verriegelungsmittel zum Verriegeln der Isolationsschaltereinrichtung in den Isolationszustand.

13. Fernisolationsschalteinrichtung (200) zum Isolieren einer ausgewählten Anlage (20, 21), wie sie in einem der vorhergehenden Ansprüche definiert ist, die zwischen mindestens einem ersten Zustand und einem zweiten Zustand umschaltbar ist, wobei die Isolationsschalteinrichtung (200) von (einer) relevanten Unterstation(en) (30) entfernt ist, die eine Energiequelle für die ausgewählte Anlage bereitstellt, und umfassend:
eine Mensch-Maschine-Schnittstelle zur Bedienung durch einen Bediener,
eine Verriegelungseinrichtung zum Verriegeln des Schalters (200) in den ersten Zustand und zum Verhindern einer Betätigung der Mensch-Maschine-Schnittstelle, es sei denn, bestimmte Zulassungen sind erfüllt,
eine Verriegelungssensoreinrichtung zum Erfassen des Betriebszustands der Verriegelungseinrichtung (910),
eine Zustandserfassungseinrichtung zum Erfassen des ersten Zustands und des zweiten Zustands, die in der Lage ist, ein maschinenlesbares Signal zu erzeugen, das den ersten und zweiten Zustand angibt; und
eine Verriegelungseinrichtung (800), die angepasst ist, um es einem Bediener zu ermöglichen, den Schalter (200) in dem zweiten Zustand zu verriegeln
wobei optional der zweite Zustand eine Isolationsposition ist.

14. Anlage, wie sie in einem der vorstehenden Ansprüche definiert ist, die ein Förderbandsystem (20, 21) ist.

## Revendications

1. Système d'isolement à distance (10) destiné à isoler une source d'énergie d'un équipement sélectionné (20, 21) pouvant être alimenté par la source d'énergie et commandé par un système de commande (260), le système comprenant uns station d'isolement à distance (12, 14) pour que l'équipement sélectionné (20, 21) soit isolé, la station d'isolement à distance (12, 14) étant en communication avec le système de commande (260) pour garantir un isolement lors d'une demande autorisée, la station d'isolement à distance (12, 14) comprenant une interface homme-machine (51) pour demander un isolement du système de commande (260), un affichage interprétable par l'homme permettant d'indiquer qu'une approbation d'isolement a été accordée depuis le système de commande (260), et un moyen de commutation d'isolement (200) permettant de communiquer au système de commande (260) qu'un isolement est effectif et **caractérisé par** le poste d'isolement à distance (12, 14) étant à distance d'une ou de plusieurs sous-station(s) (30) pertinentes fournissant la source d'énergie ; et le système d'isolement à distance (10) comprenant un ou plusieurs premier(s) interrupteur(s) de circuit (300) qui sont connectés en série avec un commutateur primaire arrêt/marche (302) pour que l'équipement sélectionné (20, 21) soit isolé, ledit ou lesdits premier(s) interrupteur(s) de circuit (300) étant commandés sur l'état d'arrêt ou d'interruption une fois que l'approbation d'isolement a été accordée ; le système (10) comprenant éventuellement un ou plusieurs deuxième(s) interrupteur(s) de circuit (304) dans une ligne d'alimentation électrique de la source d'énergie (30) à l'équipement sélectionné (20, 21), ledit ou lesdits deuxième(s) interrupteur(s) de circuit (304) étant sous la commande du système de commande (260) et étant placés dans l'état d'arrêt ou d'interruption une fois que l'autorisation d'isolement a été accordée.

2. Système (10) tel que défini dans la revendication 1, dans lequel la station d'isolement à distance (12, 14) est située à proximité de l'équipement (21) à isoler.

3. Système (10) tel que défini dans la revendication 1 ou 2 rendu inutilisable si l'équipement sélectionné (20, 21) se trouve dans un état excité (ou en marche).

4. Système (10) tel que défini dans l'une quelconque des revendications précédentes, dans lequel le fonctionnement d'un ou de plusieurs interrupteur(s) de circuit (300, 304) comprend le débrochage pour briser la ligne d'alimentation électrique ;
un ou plusieurs capteur(s) confirmant le débrochage.

5. Système (10) tel que défini dans les revendications 4 à 5 comprenant, lorsque la source d'énergie comprend l'électricité, un moyen de surveillance de tension (310) pour détecter et surveiller une tension en aval du ou des interrupteur(s) de circuit (300, 304).

6. Système (10) tel que défini dans les revendications 4 ou 5 dans lequel, en cas de fonctionnement d'un ou de plusieurs interrupteurs de circuit (300, 304) dans l'alimentation électrique à l'équipement sélectionné sur l'état d'arrêt ou d'interruption, l'autorisation de fermer l'interrupteur ou les interrupteurs de circuit (300, 304) est passée sous la commande directe et exclusive de la station d'isolement à distance (12, 14).

7. Système (10) tel que défini dans l'une quelconque des revendications précédentes, dans lequel le commutateur d'isolement (200) comprend un moyen de verrouillage (200, 800) destiné à verrouiller le commutateur d'isolement (200) dans la position d'isolement avec l'équipement sélectionné (20, 21) au moins isolé de la source d'énergie ;
le système (10) comprenant éventuellement au moins un capteur au niveau de la station d'isolement à distance (12, 14) pour détecter qu'un verrou personnel (800) a été fixé au niveau du moyen de verrouillage (200).

8. Système (10) tel que défini dans l'une quelconque des revendications précédentes comprenant un moyen d'enclenchement (910) permettant d'empêcher le commutateur d'isolement (200) d'être activé en l'absence d'approbation d'isolement.

9. Système (10) tel que défini dans l'une quelconque des revendications précédentes comprenant en outre une interface homme-machine (51) pour demander un «essai de démarrage », lors d'une activation manuelle de l'interface, un signal de communication représentatif de la demande d'« essai de démarrage » étant envoyé au système de commande (260) et un affichage interprétable par l'homme pour reconnaître le fait d'être accompli avec succès, une approbation d'isolement ayant été accordée et qu'un isolement est effectif.

10. Système (10) tel que défini dans l'une quelconque des revendications précédentes étant conçu pour continuer de manière sélective une alimentation électrique à un ou plusieurs composant(s) auxiliaire(s) dudit équipement sélectionné (20, 21) ;
ledit ou lesdits composant(s) auxiliaire(s) comprenant un système de freinage de transporteur.

11. Système tel que défini dans l'une quelconque des revendications précédentes, dans lequel ledit équipement sélectionné (20, 21) est entraîné par un moteur à vitesse variable (22, 340) et le système de commande (260) permet au moteur à vitesse variable (22, 340) de passer par la séquence d'arrêt commandé avant l'isolement.

12. Station d'isolement à distance (12, 14) destinée à isoler un équipement sélectionné (20, 21) tel que défini dans l'une quelconque des revendications précédentes, la station d'isolement à distance (12, 14) étant éloignée d'une ou de plusieurs sous-stations (30) pertinentes fournissant la source d'énergie et comprenant :
un premier moyen indicateur destiné à indiquer un état prêt de la station d'isolement à distance ;
une première interface homme-machine destinée à effectuer une demande d'isolement ;
un deuxième moyen indicateur destiné à indiquer que la demande d'isolement a été accordée ;
un moyen de commutation d'isolement manuel présentant au moins deux états de fonctionnement, notamment un état normal et un état d'isolement ; et
un moyen de verrouillage destiné à verrouiller le moyen de commutation d'isolement vers l'état d'isolement.

13. Moyen de commutation d'isolement à distance (200) destiné à isoler un équipement sélectionné (20, 21) tel que défini dans l'une quelconque des revendications précédentes pouvant être commuté entre au moins un premier état et un deuxième état, ledit moyen de commutation d'isolement (200) étant éloigné d'une ou de plusieurs sous-stations (30) pertinentes fournissant une source d'énergie à l'équipement sélectionné, et comprenant :
une interface homme-machine pour un fonctionnement par un opérateur,
un moyen d'enclenchement destiné à verrouiller le commutateur (200) vers ledit premier état et empêchant l'actionnement de l'interface homme-machine à moins que certaines autorisations soient satisfaites,
un moyen de détection d'enclenchement destiné à détecter l'état de fonctionnement du moyen d'enclenchement (910),
un moyen de détection d'état destiné à détecter ledit premier état et ledit deuxième état et capable de générer un signal lisible par machine indicatif desdits premier et deuxième états ; et
un moyen d'enclenchement (800) conçu pour permettre à un opérateur de verrouiller le commutateur (200) dans le deuxième état
ledit deuxième état étant éventuellement une position d'isolement.

14. Équipement tel que défini dans l'une quelconque des revendications précédentes étant un système de bande transporteuse (20, 21).
